# EUROPEAN PATENT APPLICATION

(11) **EP 1 139 525 A2**
(43) Date of publication of application: **04.10.2001**
(21) Application number: 01400808.0
(22) Date of filing: 29.03.2001
(51) Int. Cl.: H01S 5/14

(54) **External resonator type laser light source**

(30) Priority: 30.03.2000 JP 2000095643
(71) Applicant: ANDO ELECTRIC CO., LTD., Tokyo (JP)
(72) Inventor: Yagi, Toshiyuki, Ota-ku, Tokyo (JP)
(74) Representative: Ilgart, Jean-Christophe

(57) **Abstract**

The external resonator type laser light source of the present invention is equipped with a rotation mechanism for varying a selected wavelength according to the angle of a mirror (3) and a semiconductor laser (1) provided with a reflection preventive film (1A) on one end surface, and which converts outgoing light from an end surface on the reflection preventive film side of the semiconductor laser to parallel light, returns this parallel light to a diffraction grating (2) with the mirror after selecting the wavelength of this parallel light with the diffraction grating, and excites the laser by again selecting a wavelength with the diffraction grating and returning the light to the semiconductor laser; wherein, a wavelength monitor (15) is provided that couples either outgoing light (A) from the end surface of the semiconductor laser not provided with the reflection preventive film or zero-order light (B) of the diffraction grating to an optical fiber (9), and into which any of the light which is not used for coupling to the optical fiber enters.

## Description

### BACKGROUND OF THE INVENTION

### Field of the Invention

The present invention relates to an external resonator type laser light source used in the field of optical communication.

### Description of the Related Art

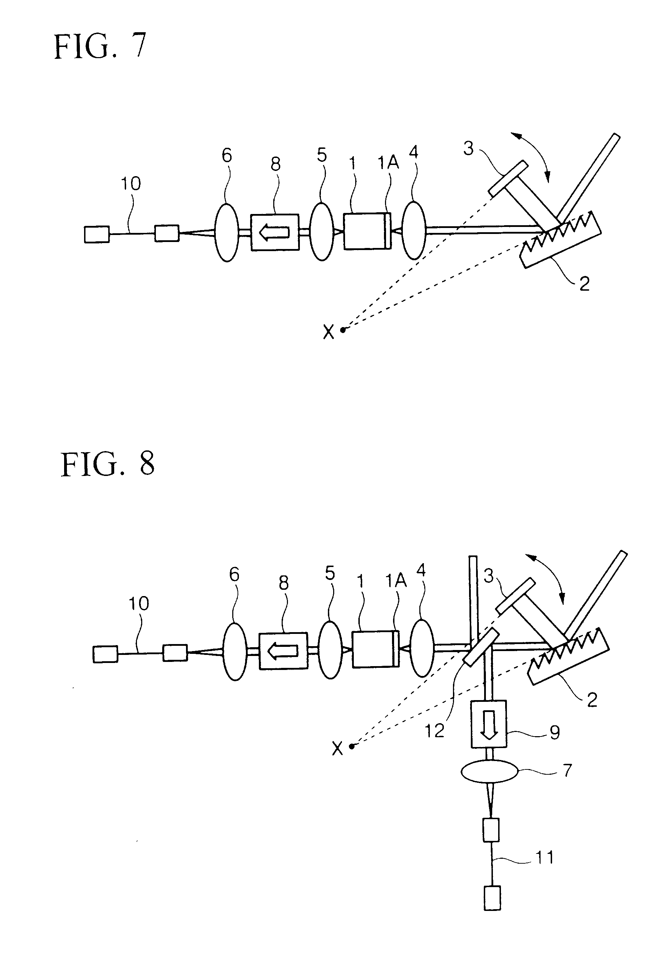

An explanation of an external resonator type laser light source of the prior art is provided using Figs. 7 through 12.

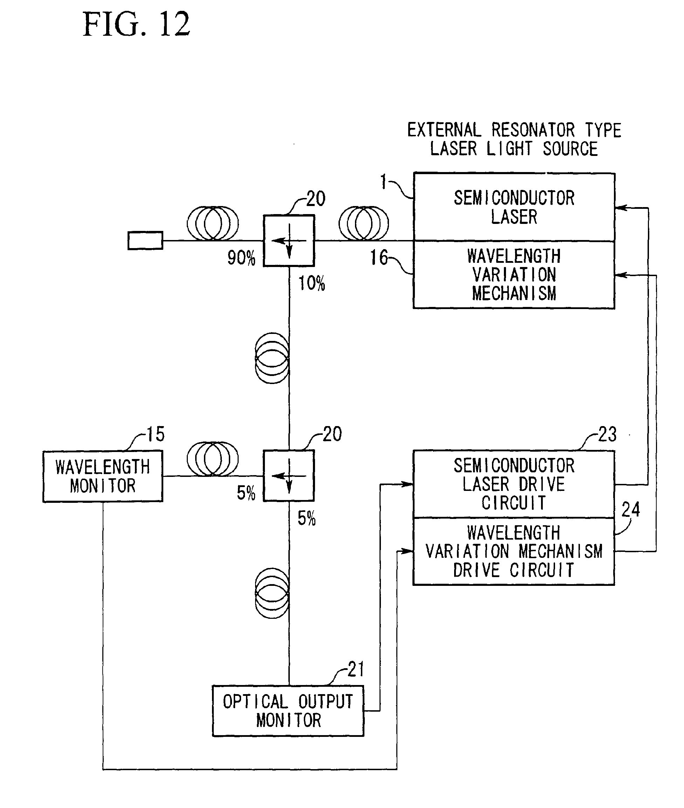

Figs. 7 through 11 are schematic drawings showing one example of an external resonator type laser light source of the prior art, while Fig. 12 is a block diagram showing one example of an external resonator type laser light source of the prior art.

In Figs. 7 through 11, reference symbol 1 indicates a semiconductor laser; 2 a diffraction grating; 3 a mirror; 4, 5, 6 and 7 lenses; 8 and 9 optical isolators; 10 and 11 optical fibers; 12 a beam splitter; 13 a band pass filter; and 14 a partial reflecting mirror.

The external resonator type laser light source of the prior art shown in Fig. 7 is equipped with a rotation mechanism for varying a selected wavelength according to the angle of the mirror 3, is provided with a reflection preventive film 1A on one end surface of the semiconductor laser 1, converts outgoing light from this end surface of the reflection preventive film side into parallel light by the lens 4, returns this parallel light to the diffraction grating 2 after selecting a wavelength with the diffraction grating 2, and excites the laser by returning this light to the above semiconductor laser 1 after again selecting a wavelength with the diffraction grating 2.

Outgoing light from the end surface of the semiconductor laser 1 not provided with the reflection preventive film is converted into parallel light by the lens 5 and passes through the optical isolator 8, and is coupled to the optical fiber 10 after being collected by the lens 6.

The external resonator type laser light source shown in Fig. 8 is the external resonator type laser light source shown in Fig. 7 equipped with the beam splitter 12 between the semiconductor laser 1 and the diffraction grating 2, wherein return light extracted by the above beam splitter 12 passes through the optical isolator 9, is collected by the lens 7, and is then coupled to the optical fiber 11.

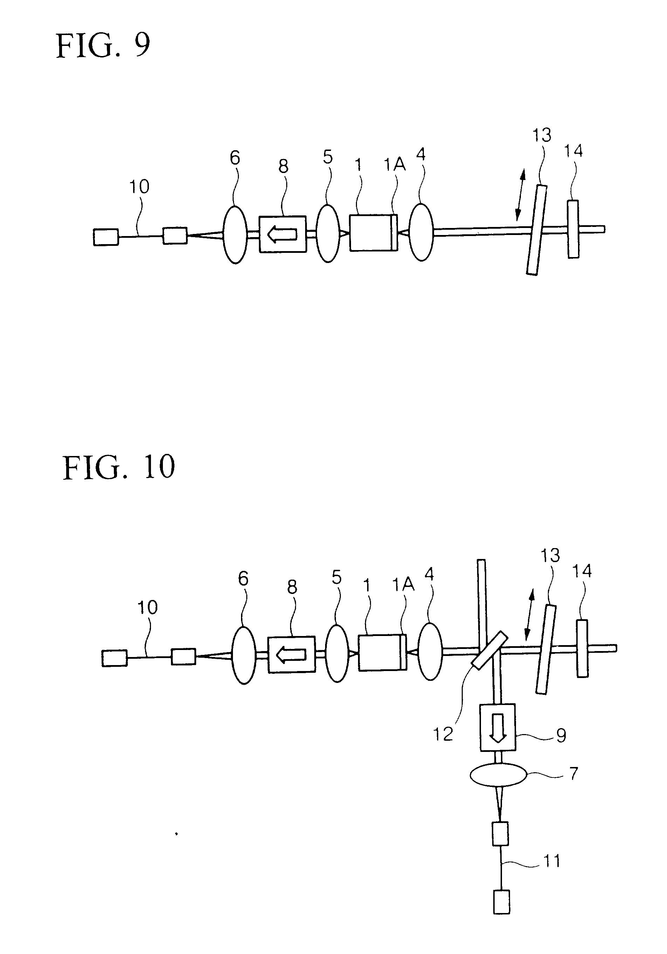

The external resonator type laser light source shown in Fig. 9 is the external resonator type laser light source shown in Fig. 7 equipped with a slide mechanism for varying a selected wavelength with the band pass filter 13 by using the band pass filter 13 that continuously changes the film thickness in place of the diffraction grating 2, uses the partial reflecting mirror 14 for the mirror, and arranges the partial reflecting mirror behind the band pass filter 13.

The external resonator type laser light source shown in Fig. 10 is the external resonator type laser light source of the prior art shown in Fig. 9 equipped with the beam splitter 12 between the semiconductor laser 1 and the band pass filter 13, wherein return light extracted by the above beam splitter 12 passes through the optical isolator 9, is gathered by the lens 7, and is coupled to the optical fiber 11.

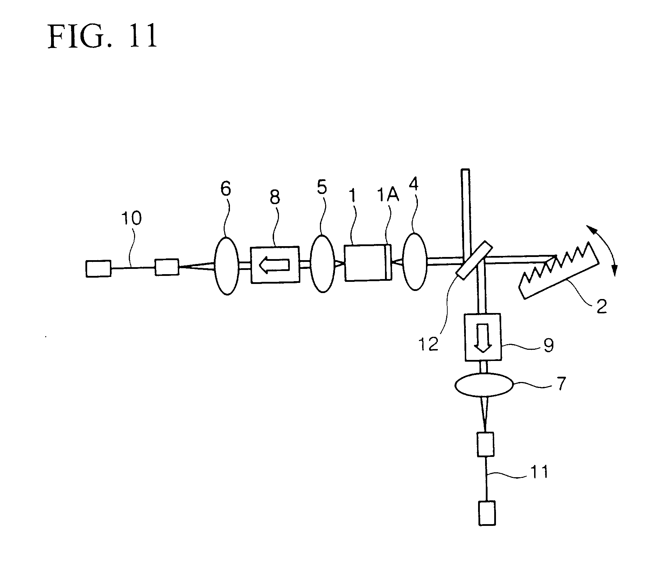

The external resonator type laser light source shown in Fig. 11 is the external resonator type laser light source shown in Fig. 8 equipped with a rotation mechanism for varying a selected wavelength according to the angle of the diffraction grating 2 by selecting a wavelength with the above diffraction grating 2 without using the mirror 3, and exciting a laser by returning that light to the above semiconductor laser 1.

In addition, in the block diagram of an external resonator type laser light source of the prior art shown in Fig. 12, together with controlling the drive current of a semiconductor laser so as to maintain a constant optical output by splitting the outgoing light from the optical fiber by an optical coupler and the like, directing that light into an optical output monitor and a wavelength monitor, and returning the signal from the optical output monitor to a semiconductor laser drive circuit (APC driving), a wavelength variation mechanism is controlled so as to excite the laser at a set wavelength by returning the signal of the wavelength monitor to a wavelength variation mechanism drive circuit.

However, in the above-described conventional external resonator type laser light source, since the outgoing light from the optical fiber enters the optical output monitor and the wavelength monitor, 10% of the outgoing light is lost for example.

### SUMMARY OF THE INVENTION

In order to solve the above problems, the present invention discloses an external resonator type laser light source which is equipped with a rotation mechanism for varying a selected wavelength according to the angle of a mirror and a semiconductor laser provided with a reflection preventive film on one end surface, and which converts outgoing light from an end surface on the reflection preventive film side of the semiconductor laser into parallel light, returns this parallel light to a diffraction grating with a mirror after selecting the wavelength of said parallel light with a diffraction grating, and excites the laser by again selecting a wavelength with the diffraction grating and returning to said semiconductor laser; wherein, a wavelength monitor is provided that couples either outgoing light from the end surface of the semiconductor laser not provided with the reflection preventive film or zero-order light of the diffraction grating to a first optical fiber, and into which any of the light which is not used for coupling to the first optical fiber enters.

In addition, the present invention also discloses the external resonator type laser light source as described above which is equipped with a beam splitter between the semiconductor laser and the diffraction grating, and which couples return light extracted by said beam splitter to a second optical fiber; wherein, a wavelength monitor is provided that couples either outgoing light from the end surface of the semiconductor laser not provided with the reflection preventive film, zero-order light of the diffraction grating, or reflected light of the beam splitter to the first optical fiber, and into which any of the light which is not used for coupling to the first optical fiber enters.

Furthermore, this external resonator type laser light source may be equipped with a rotation mechanism for varying a selected wavelength according to the angle of the diffraction grating, which selects a wavelength with the diffraction grating without using the mirror and returns it to the semiconductor laser; wherein, a wavelength monitor is provided that couples either outgoing light from the end surface of the semiconductor laser not provided with the reflection preventive film, or reflected light of the beam splitter to the first optical fiber, and into which any of the light which is not used for coupling to the first optical fiber enters.

In addition, the present invention also discloses the external resonator type laser light source as described above which is equipped with a slide mechanism for varying a selected wavelength of a band pass filter, which uses a band pass filter that continuously changes the film thickness in place of the diffraction grating, and which uses a partial reflecting mirror for the mirror, and arranges the partial reflecting mirror behind the band pass filter; wherein, the wavelength monitor is provided that couples either outgoing light from the end surface of the semiconductor laser not provided with the reflection preventive film, or transmitted light of the mirror to the first optical fiber, and into which any of the light which is not used for coupling to the first optical fiber is enters.

Furthermore, this external resonator type laser light source may be equipped with a beam splitter between the semiconductor laser and the band pass filter, which couples return light extracted by the beam splitter to the second optical fiber; wherein, the wavelength monitor is provided that couples either outgoing light from the end surface of the semiconductor laser not provided with the reflection preventive film, reflected light of said beam splitter or transmitted light of the mirror to the first optical fiber, and into which any of the light which is not used for coupling to the first optical fiber enters.

### BRIEF DESCRIPTION OF THE DRAWINGS

Fig. 1 is a schematic drawing showing an example of an external resonator type laser light source according to the present invention.
Fig. 2 is a schematic drawing showing another example of an external resonator type laser light source according to the present invention.
Fig. 3 is a schematic drawing showing another example of an external resonator type laser light source according to the present invention.
Fig. 4 is a schematic drawing showing another example of an external resonator type laser light source according to the present invention.
Fig. 5 is a schematic drawing showing another example of an external resonator type laser light source according to the present invention.
Fig. 6 is a block diagram showing an example of an external resonator type laser light source according to the present invention.
Fig. 7 is a schematic drawing showing an example of an external resonator type laser light source according to the prior art.
Fig. 8 is a schematic drawing showing another example of an external resonator type laser light source according to the prior art.
Fig. 9 is a schematic drawing showing another example of an external resonator type laser light source according to the prior art.
Fig. 10 is a schematic drawing showing another example of an external resonator type laser light source according to the prior art.
Fig. 11 is a schematic drawing showing another example of an external resonator type laser light source according to the prior art.
Fig. 12 is a block diagram showing an example of an external resonator type laser light source according to the prior art.

### DETAILED DESCRIPTION OF THE PREFERRED EMBODIMENTS

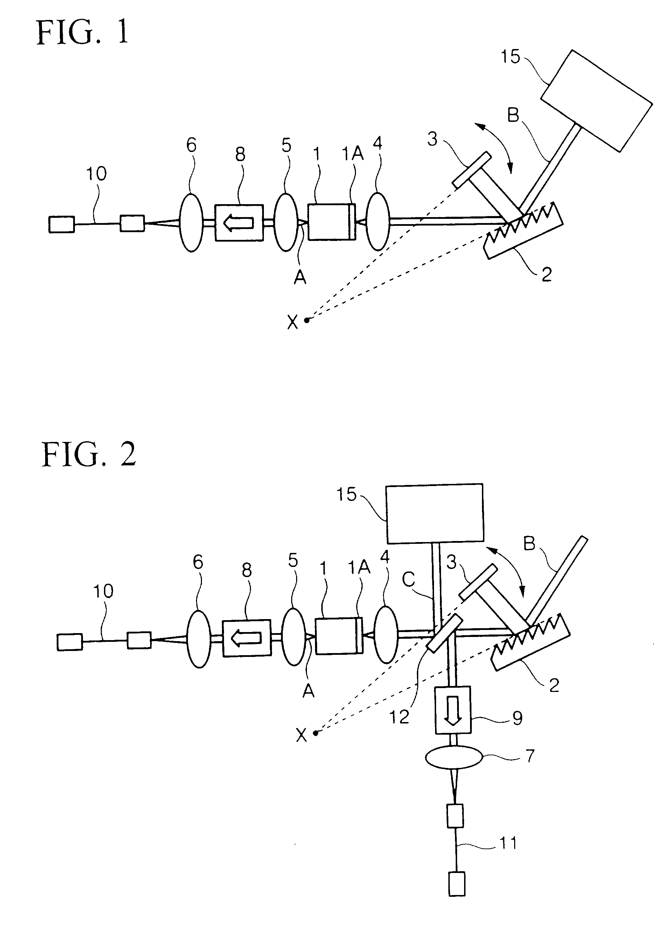

The following provides an explanation of an external resonator type laser light source according to the present invention with reference to the drawings of Figs. 1 through 6.

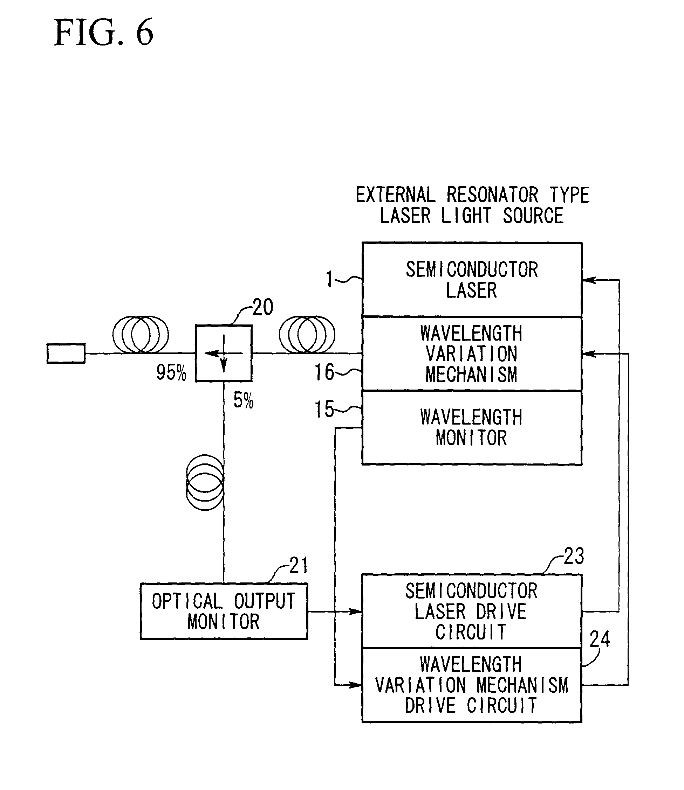

Figs. 1 through 5 are schematic drawings showing examples of external resonator type laser light sources according to the present invention, while Fig. 6 is a block diagram showing an example of an external resonator type laser light source according to the present invention.

In Figs. 1 through 5, reference symbol 1 indicates a semiconductor laser; 2 a diffraction grating; 3 a mirror; 4, 5, 6 and 7 lenses; 8 and 9 optical isolators; 10 and 11 optical fibers; 12 a beam splitter; 13 a band pass filter; 14 a partial reflecting mirror; and 15 a wavelength monitor.

In the external resonator type laser light source of the embodiment shown in Fig. 1, a reflection preventive film 1A is provided on one end surface of the semiconductor laser 1, and an outgoing light from this end surface of the reflection preventive film side is converted into parallel light by the lens 4. This parallel light is led to the diffraction grating 2, and the parallel light that has entered this diffraction grating 2 is divided into a radial form for each wavelength. The light of a wavelength that enters perpendicular to the reflecting surface of the mirror 3 again enters the diffraction grating 2, and follows the original light path after being divided again, returning to the semiconductor laser 1 and resulting in laser excitation. This type of configuration is referred to as the Littman type. Since light travels back and forth within an external resonator due to the diffraction grating 2 resulting in the selection of two wavelengths, this configuration has superior wavelength selectivity, and is known as one of the most common methods.

A rotation mechanism is provided for varying the selected wavelength according to the angle of the mirror 3 in this embodiment, so that the wavelength that enters perpendicular to the reflecting surface of the mirror 3 can be changed by changing the angle of the mirror 3. Location X of the mirror's center of rotation is preferably arranged at the location described in Japanese Unexamined Patent Application, First Publication No. 2000-164979, and enables continuous, uninterrupted variation by mode hopping during wavelength variation.

In this embodiment, outgoing light A from the end surface of the semiconductor laser 1 not provided with a reflection preventive film 1A is converted into parallel light by the lens 5 and passes through the optical isolator 8, and is coupled to the optical fiber 10 after being collected by the lens 6, while zero-order light B of the diffraction grating 2 enters the wavelength monitor 15.

Furthermore, light is coupled to the optical fiber 10 and light entering the wavelength monitor 15 may be either outgoing light A from the end surface of the semiconductor laser 1 not provided with a reflection preventive film, or zero-order light B of the diffraction grating 2.

The light which is coupled to the optical fiber 10 can also enter the wavelength monitor 15.

Here, a wavelength measurement apparatus disclosed in Japanese Unexamined Patent Application, First Publication No. 2000-234959 can be provided as the wavelength monitor 15, for example.

The embodiment of the external resonator type laser light source shown in Fig. 2 is equipped with the beam splitter 12 between the semiconductor laser 1 and the diffraction grating 2 that extracts a portion of the return light returned from the diffraction grating 2 to the semiconductor laser 1 in the external resonator type laser light source of Fig. 1. In this embodiment, return light extracted by the beam splitter 12 passes through the optical isolator 9, is collected by the lens 7, and is coupled to the optical fiber (second optical fiber) 11. Since this return light is light immediately following two rounds of wavelength selection that has traveled back and forth due to the diffraction grating 2, extremely uniform, single-wavelength light can be obtained that is free of natural emitted light components emitted from the semiconductor laser 1 (see Japanese Unexamined Patent Application, First Publication No. 11-126943).

In this embodiment, outgoing light A from the end surface of the semiconductor laser 1 not provided with a reflection preventive film 1A is converted into parallel light by the lens 5 and passes through the optical isolator 8, and is coupled to the optical fiber 10 after being collected by the lens 6, while reflected light C of the beam splitter 12 enters the wavelength monitor 15.

Furthermore, light that is coupled to the optical fiber 10 and light entering the wavelength monitor 15 may be any of outgoing light A from the end surface of the semiconductor laser 1 not provided with a reflection preventive film, zero-order light B of the diffraction grating 2, or reflected light C of the beam splitter 11.

The light which is coupled to the optical fiber 10 can also enter the wavelength monitor 15.

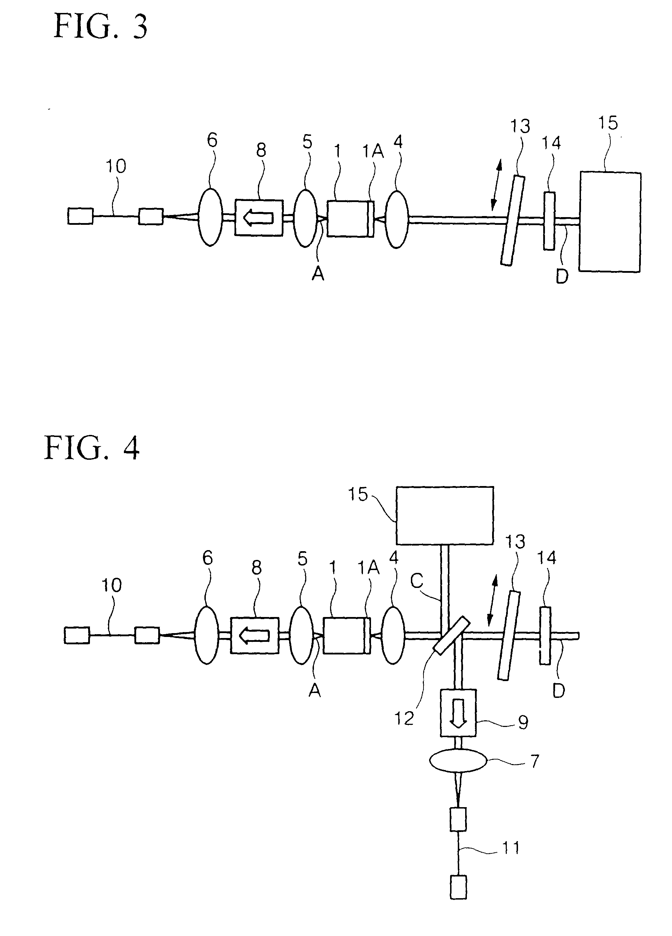

The embodiment of the external resonator type laser light source shown in Fig. 3 uses the band pass filter 13 that continuously changes the film thickness in place of the diffraction grating 2, uses the partial reflecting mirror 14 for the mirror, and arranges the partial reflecting mirror 14 behind the band pass filter 13 in the external resonator type laser light source shown in Fig. 1. Only parallel light of a selected wavelength that has entered this band pass filter 13 passes through the band pass filter 13, after which it is reflected by the partial reflecting mirror 14, again passes through the band pass filter 13, and returns to the semiconductor laser 1 resulting in laser excitation.

This external resonator type laser light source is equipped with a slide mechanism for varying the selected wavelength according to the position of the band pass filter 13, and therefore, the wavelength of light that passes through the band pass filter 13 can be changed by sliding the band pass filter 13 in a direction in which the film thickness changes.

In this embodiment, outgoing light A from the end surface of the semiconductor laser 1 not provided with a reflection preventive film 1A is converted into parallel light by the lens 5 and passes through the optical isolator 8, and is coupled to the optical fiber 10 after being collected by the lens 6, while transmitted light D of the partial reflecting mirror enters the wavelength monitor 15.

Furthermore, light coupled to the optical fiber 10 and light entering the wavelength monitor 15 may be either outgoing light A from the end surface of the semiconductor laser 1 not provided with a reflection preventive film, or transmitted light D of the partial reflecting mirror 14.

The light which is coupled to the optical fiber 10 can also enter the wavelength monitor 15

The embodiment of the external resonator type laser light source shown in Fig. 4 is equipped with the beam splitter 12 between the semiconductor laser 1 and the band pass filter 13 that extracts a portion of the return light returned from the band pass filter 13 to the semiconductor laser 1 in the external resonator type laser light source of Fig. 3. In this embodiment, return light extracted by the beam splitter 12 passes through the optical isolator 9, is collected by the lens 7, and is coupled to the optical fiber 11.
Since this return light is light immediately following two rounds of wavelength selection that has traveled back and forth due to the band pass filter 13, extremely uniform, single-wavelength light can be obtained that is free of natural emitted light components emitted from the semiconductor laser 1 (see Japanese Unexamined Patent Application, First Publication No. 11-126943).

In this embodiment, outgoing light A from the end surface of the semiconductor laser 1 not provided with a reflection preventive film 1A is converted into parallel light by the lens 5 and passes through the optical isolator 8, and is coupled to the optical fiber 10 after being collected by the lens 6, while reflected light C of the beam splitter 12 enters the wavelength monitor 15.

Furthermore, light coupled to the optical fiber 9 and light entering the wavelength monitor 15 may be any of outgoing light A from the end surface of the semiconductor laser 1 not provided with a reflection preventive film, reflected light C of the beam splitter 12, or transmitted light D of the partial reflecting mirror 14.

In addition, in the case of using the mirror 3 in place of the partial reflecting mirror 14, light coupled to the optical fiber 10 and light entering the wavelength monitor 15 may be either outgoing light A from the end surface of the semiconductor laser 1 not provided with a reflection preventive film, or reflected light C of the beam splitter 12.

The light which is coupled to the optical fiber 10 can also enter the wavelength monitor 15.

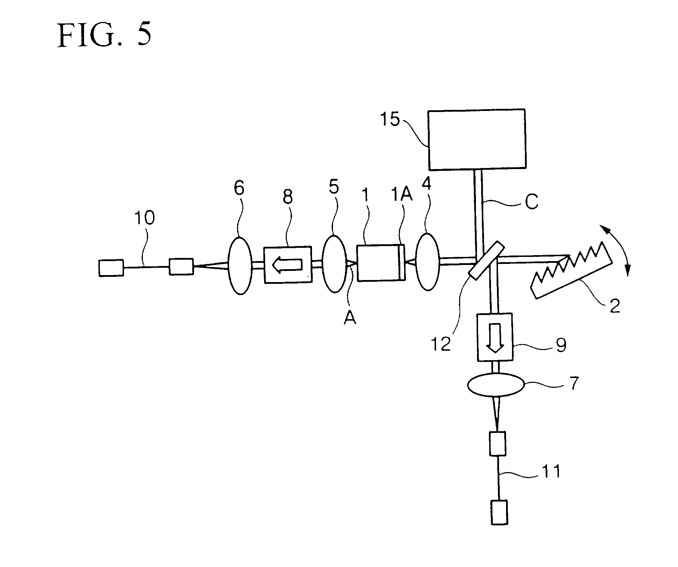

The embodiment shown in Fig. 5 is the external resonator type laser light source that returns light to a semiconductor laser after selecting a wavelength with the diffraction grating 2 without using the mirror 3 in the external resonator type laser light source shown in Fig. 2. Parallel light that has entered this diffraction grating 2 is divided into a radial form for each wavelength, and only light of a wavelength that coincides with the original light path is returned to the semiconductor laser 1 resulting in laser excitation. This type of configuration is referred to as the Lithrow type, and is known as one of the most basic methods.

A rotation mechanism is provided for varying the selected wavelength according to the angle of the diffraction grating 2 in this embodiment, so that the wavelength of light divided with the diffraction grating 2 that coincides with the original light path can be changed by changing the angle of the diffraction grating 2.

In this embodiment, outgoing light A from the end surface of the semiconductor laser 1 not provided with a reflection preventive film 1A is converted into parallel light by the lens 5 and passes through the optical isolator 8, and is coupled to the optical fiber 10 after being collected by the lens 6, while reflected light C of the beam splitter 12 enters the wavelength monitor 15.

Furthermore, light coupled to the optical fiber 10 and light entering the wavelength monitor 15 may be either outgoing light A from the end surface of the semiconductor laser 1 not provided with a reflection preventive film, or reflected light C of the beam splitter 12.

The light which is coupled to the optical fiber 10 can also enter the wavelength monitor 15.

Fig. 6 is a block diagram showing an example of an external resonator type laser light source according to the present invention.

In the block diagram, together with controlling the drive current of a semiconductor laser so as to maintain a constant optical output by splitting the outgoing light from the optical fiber by an optical coupler and the like, directing the light into an optical output monitor and directing light other than the outgoing light into the wavelength monitor, and returning the signal from the optical output monitor to a semiconductor laser drive circuit (APC driving), a wavelength variation mechanism is controlled so as to excite the laser at a set wavelength by returning the signal of the wavelength monitor to a wavelength variation mechanism drive circuit.

In the external resonator type laser light source of the present invention, since light other than the outgoing light enters the wavelength monitor, loss of the outgoing light can be reduced. In the above-described embodiment, the loss is reduced to 5% for example.

The present invention is not necessarily limited to the above-mentioned embodiments, and easily allows various other variations.

## Claims

1. An external resonator type laser light source equipped with a rotation mechanism for varying a selected wavelength according to the angle of a mirror and a semiconductor laser provided with a reflection preventive film on one end surface, which converts outgoing light from an end surface on the reflection preventive film side of said semiconductor laser into parallel light, returns this parallel light to a diffraction grating with a mirror after selecting the wavelength of said parallel light with said diffraction grating, and excites the laser by again selecting a wavelength with said diffraction grating and returning said light to said semiconductor laser; wherein, a wavelength monitor is provided that couples either outgoing light from the end surface of said semiconductor laser not provided with said reflection preventive film or zero-order light of said diffraction grating to a first optical fiber, and into which any of the light which is not used for coupling to the first optical fiber enters .

2. An external resonator type laser light source according to claim 1, which is equipped with a beam splitter between said semiconductor laser and said diffraction grating, and which couples return light extracted by said beam splitter to a second optical fiber; wherein, said wavelength monitor is provided that couples either outgoing light from the end surface of said semiconductor laser not provided with said reflection preventive film, zero-order light of said diffraction grating or reflected light of said beam splitter to the first optical fiber, and into which any of the light which is not used for coupling to the first optical fiber enters.

3. An external resonator type laser light source according to claim 1, which is equipped with a slide mechanism for varying a selected wavelength of a band pass filter, and which uses the band pass filter that continuously changes the film thickness in place of said diffraction grating, uses a partial reflecting mirror for the mirror, and arranges said partial reflecting mirror behind the band pass filter; wherein, said wavelength monitor is provided that couples either outgoing light from the end surface of said semiconductor laser not provided with said reflection preventive film or transmitted light of said mirror to the first optical fiber, and into which any of the light which is not used for coupling to the first optical fiber enters.

4. An external resonator type laser light source according to claim 3, which is equipped with a beam splitter between said semiconductor laser and said band pass filter, and which couples return light extracted by said beam splitter to a second optical fiber; wherein, said wavelength monitor is provided that couples outgoing light from the end surface of said semiconductor laser not provided with said reflection preventive film, reflected light of said beam splitter, or transmitted light of said mirror to the first optical fiber, and into which any of the light which is not used for coupling to the first optical fiber enters.

5. An external resonator type laser light source according to claim 2, which is equipped with a rotation mechanism for varying a selected wavelength according to the angle of said diffraction grating, and which selects a wavelength with said diffraction grating without using said mirror and returns said light to said semiconductor laser; wherein, said wavelength monitor is provided that couples either outgoing light from the end surface of said semiconductor laser not provided with said reflection preventive film or reflected light of said beam splitter to the first optical fiber, and into which any of the light which is not used for coupling to the first optical fiber enters.
